Europäisches Patentamt

European Patent Office

Office européen des brevets

(19)

(11) Veröffentlichungsnummer: **0 203 544**

**A2**

# EUROPÄISCHE PATENTANMELDUNG

(12)

(21) Anmeldenummer: **86107000.1**

(22) Anmeldetag: **23.05.86**

(51) Int. Cl.⁴: **H01H 1/40** , H01H 13/70

(30) Priorität: **31.05.85 DE 3519584**

(43) Veröffentlichungstag der Anmeldung:
**03.12.86 Patentblatt 86/49**

(84) Benannte Vertragsstaaten:
**AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Ruttkowski, Lothar**
**Schlüsselbergstrasse 46**
**D-8000 München 80(DE)**

(54) **Kontaktflächen für Schalteinrichtungen.**

(57) Kontaktflächen für Tasten oder Tastaturen, bei denen Leiterbahnen zu Kontaktflächen (6, 7) geführt sind.

Zweck der vorliegenden Erfindung ist es, die im Siebdruckverfahren aufgebrachten Kontaktflächen (6, 7) so zu gestalten, daß zweimaliger Siebdruckvorgang erübrigt. Nunmehr bestehen die Kontaktflächen (6, 7) aus auf einer Basis (1) aufgebrachten Graphitflächen, die mit jeweils einer großflächig als Elektrode (2, 3) gestalteten Leiterbahn seitlich kontaktiert sind.

EP 0 203 544 A2

Kontaktflächen für Schalteinrichtungen

Die Erfindung bezieht sich auf Kontaktflächen für Schalteinrichtungen, insbesondere für Tasten oder Tastaturen, bei welchen Leiterbahnen zu den Kontaktflächen geführt sind.

Üblicherweise werden derartige Kontaktflächen so gestaltet, daß auf einer Leiterplatte oder Folie einstückig mit Leiterbahnen ausgebildete Kupferflecken aufgebracht sind, die mit einer Graphitschicht abgedeckt sind. Dabei muß wegen der Gefahr der Korrosion die Graphitschicht so dicht sein, daß die Kupferflecken völlig abgedeckt sind. Dies ist meist nur durch zweimaligen Siebdruck möglich, um die Poren des Graphits völlig zu verschließen.

Aufgabe der Erfindung ist es, die Kontaktflächen derart zu gestalten, daß ein zweimaliger Siebdruckvorgang sich erübrigt.

Gelöst wird die Aufgabe dadurch, daß die Kontaktflächen aus auf einer Basis aufgebrachten Graphitflächen bestehen, die mit jeweils einer großflächig als Elektrode ausgebildeten Leiterbahn seitlich kontaktiert sind.

Durch diese Anordnung ist im kontaktgebenden Bereich lediglich die Graphitschicht vorhanden. Damit ist gegenüber der bekannten Lösung sichergestellt, daß es bei längerem Gebrauch zu keinerlei Freilegung des Kupfers kommen kann, was wegen Korrosion zu Betriebsstörungen führen könnte.

Eine vorteilhafte Weiterbildung besteht darin, daß die Graphitflächen aus einer durch einen Arbeitsgang aufgebrachten Polymer-Dickfilm-Siebdruckpaste bestehen.

Diese Ausgestaltung ist kostengünstig und problemlos in der Fertigung.

Um die Elektrode vor Umwelteinflüssen zu - schützen, ist es zweckmäßig, daß die Leiterbahnen und die Elektroden mit einer Schutzschicht verschlossen sind.

Diese Schutzschicht muß die Elektrode hermetisch abschließen und besteht zweckmäßigerweise aus einem Lötstoplack.

Im folgenden sei die Erfindung anhand einer Abbildung näher erläutert.

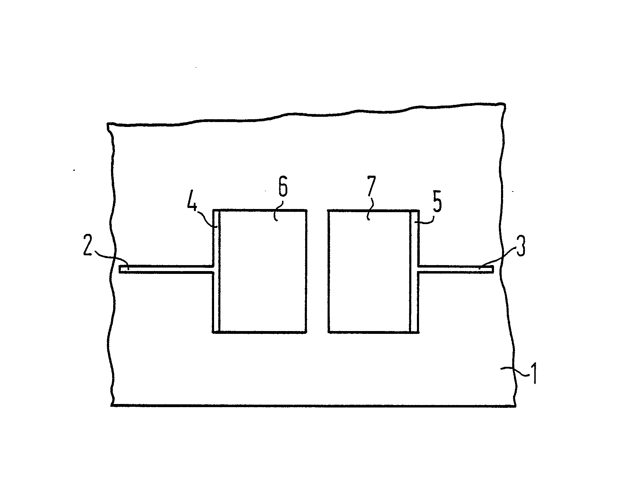

Die Abbildung zeigt einen Teil einer Leiterplatte 1, auf der Leiterbahnen 2, 3 aufgebracht sind, die in Elektroden 4, 5 enden. An diese Elektroden 4, 5 schließen sich Graphitflächen 6, 7 derart an, daß diese mit den Elektroden kontaktiert sind. Die Elektroden wie auch die Leiterbahnen sind mit einer hier nicht gezeigten Schutzschicht versehen, um eine Korrosion zu unterbinden.

Bezugszeichenliste

1 Leiterplatte

2 Leiterplatte

3 Leiterplatte

4 Elektrode

5 Elektrode

6 Graphitfläche

7 Graphitfläche

**Ansprüche**

1. Kontaktflächen für Schalteinrichtungen, insbesondere für Tasten oder Tastaturen, bei welchen Leiterbahnen zu den Kontaktflächen geführt sind,

**dadurch gekennzeichnet** , daß die Kontaktflächen (6, 7) aus auf einer Basis (1) (Leiterplatte, Folie) aufgebrachten Graphitflächen bestehen, die mit jeweils einer großflächig als Elektrode (2, 3) ausgebildeten Leiterbahn seitlich kontaktiert sind.

2. Kontaktflächen nach Anspruch 1, **dadurch gekennzeichnet** , daß die Graphitflächen aus einer durch einen Arbeitsgang aufgebrachten Polymer-Dickfilm-Siebdruckpaste bestehen.

3. Kontaktflächen nach Anspruch 1, **dadurch gekennzeichnet** , daß die Leiterbahnen und die Elektroden mit einer Schutzschicht verschlossen sind.

4. Kontaktflächen nach Anspruch 3, **dadurch gekennzeichnet** , daß die Schutzschicht aus Lötstoplack besteht.